# EUROPEAN PATENT SPECIFICATION

(11) **EP 1 424 363 B1**
(45) Date of publication and mention of the grant of the patent: **14.02.2007**
(21) Application number: 03257536.7
(22) Date of filing: 28.11.2003
(51) Int. Cl.: C08L 83/04

(54) **Silicone resin composition for led devices**
Silikonharz Zusammensetzung für LED Bauteile
Composition de resine silicone pour dispositifs a diodes electroluminescentes

(30) Priority: 29.11.2002 JP 2002347603
(43) Date of publication of application: 02.06.2004
(73) Proprietor: Shin-Etsu Chemical Co., Ltd., Chiyoda-ku, Tokyo (JP)
(72) Inventor: Miyoshi, Kei c/o Shin-Etsu Chemical Co., Ltd., Usui-gun Gunma-ken (JP)
(74) Representative: Stoner, Gerard Patrick

(56) References cited:
- WO-A-01/82385
- US-A- 5 739 199
- US-B1- 6 285 513

## Description

### BACKGROUND

This invention relates to the use of silicone resin compositions in making light-emitting diode (LED) devices, and more particularly using silicone resin compositions useful for any one, more or all of protection, bonding, wavelength alteration or adjustment, and lens formation in LED devices. The uses, and corresponding products, are aspects of the invention.

In the prior art, epoxy resins are often used as the sealing material for LED devices. With respect to silicone resins, JP-A 10-228249 discloses their use as mounting members, JP-A 10-242513 (corresponding to US-A-5,998,925, US-A-6,614,179, US-A-6,069,440 and US-A-6,608,332) discloses their use as lenses, and JP-A 2000-123981 attempts to use silicone resins as wavelength adjusting coatings. Few silicone resins are actually used in such applications. WO-A-01/82385 mentions silicone resins in general as being useful matrix materials for embedding light-emitting semiconductors.

With a great focus now being directed to white LED, new problems emerge like UV-induced yellowing of epoxy resin encapsulants during actual use, which has been negligible, and cracking of encapsulants by heat generation increased as a result of size reduction. It is urgently needed to overcome these problems.

An object of the invention is to provide a silicone resin composition, used with light-emitting diode (LED) devices, that cures into a product which is fully transparent and is little discolored over time.

The present invention provides the use, in the manufacture of a light-emitting diode (LED) device, of a silicone resin composition curable to a transparent product and comprising:
(A) 100 parts by weight of liquid or solid organopolysiloxane having a viscosity of at least 10 mPa·s at 25°C and represented by the average compositional formula (1):

   RₙSiO_{(4-n)/2}

   wherein groups R are selected independently from substituted or unsubstituted monovalent hydrocarbon groups, alkoxy groups and hydroxyl group, 0.1 to 80 mol% of the entire R groups being alkenyl groups, and n is a positive number satisfying 1 ≤ n < 2;
(B) 2 to 100 parts by weight of organohydrogenpolysiloxane having at least two SiH bonds per molecule, being represented by the average compositional formula (2) and having a viscosity of up to 1,000 mPa·s at 25°C:

   R'ₐH_{b}SiO_{(4-a-b)/2} (2)

   wherein groups R' are selected independently from substituted or unsubstituted monovalent hydrocarbon groups, excluding aliphatic unsaturated hydrocarbon groups, a is a positive number from 0.7 to 2.1, b is a positive number from 0.001 to 1.0, and 0.8 ≤ a+b ≤ 2.6, and/or
   organohydrogensilane represented by the formula R'_{c}SiH_{(4-c)} wherein R' is as defined above and c is 1 or 2;
(C) a catalytic amount of addition reaction catalyst.

The silicone resin composition cures into a transparent product having heat resistance and discoloration resistance.

The resulting LED devices are a further aspect of the invention.

### FURTHER EXPLANATIONS; OPTIONS AND PREFERENCES

The silicone resin composition used in the present invention includes as essential components,
(A) a silicone resin having at least two alkenyl groups bonded to silicon atoms in a molecule,
(B) an organohydrogensilane and/or organohydrogenpolysiloxane having at least two hydrogen atoms bonded to silicon atoms in a molecule, and
(C) an addition reaction catalyst. For actual in-line use, a silicone resin composition of the heat curing type is preferred because it can be cured within a brief time.

The silicone resin (A) is a liquid or solid organopolysiloxane of branched or three-dimensional network structure having a viscosity of at least 10 mPa·s at 25°C, represented by the average compositional formula (1).

RₙSiO_{(4-n)/2} (1)

Herein R is independently a substituted or unsubstituted monovalent hydrocarbon group, alkoxy group or hydroxyl group, 0.1 to 80 mol% of the entire R groups being alkenyl groups, and n is a positive number of 1 ≤ n < 2, preferably 1 ≤ n ≤ 1.8, more preferably 1 ≤ n s 1.5.

In formula (1), the silicon atom-bonded, substituted or unsubstituted, monovalent hydrocarbon groups represented by R are generally those of 1 to 12 carbon atoms, preferably 1 to 8 carbon atoms, for example, alkyl groups such as methyl, ethyl, propyl, isopropyl, butyl, isobutyl, tert-butyl, pentyl, neopentyl, hexyl, cyclohexyl, octyl, nonyl and decyl, aryl groups such as phenyl, tolyl, xylyl and naphthyl, aralkyl groups such as benzyl, phenylethyl, and phenylpropyl, alkenyl groups such as vinyl, allyl, propenyl, isopropenyl, butenyl, hexenyl, cyclohexenyl, and octenyl, substituted ones of the foregoing groups in which some or all of the hydrogen atoms are substituted with halogen atoms (e.g., fluoro, bromo, chloro), cyano groups or the like, such as halo-substituted alkyl groups like chloromethyl, chloropropyl, bromoethyl and trifluoropropyl, and cyanoethyl.

At least two of the R groups must be alkenyl groups, preferably of 2 to 8 carbon atoms, more preferably 2 to 6 carbon atoms. The content of alkenyl groups is 0.1 to 80 mol%, preferably about 0.5 to 50 mol%, more preferably about 1 to 30 mol% of the entire organic groups R (substituted or unsubstituted monovalent hydrocarbon groups).

Of the above-described silicone resins as component (A), a silicone resin having a high phenyl content is more preferred because the incorporation of phenyl groups in the resin is effective to provide a high refractive index. The more preferred silicone resin has the average compositional formula (1-1).

Rₚ(C₆H₅)_{q}SiO_{(4-p-q)/2} (1-1)

Herein R is as defined above, and p and q are positive numbers satisfying 1 ≤ p+q < 2, preferably 1 ≤ p+q ≤ 1.8, more preferably 1 ≤ p+q ≤ 1.5, and 0.20 ≤ q/(p+q) ≤ 0.95, preferably 0.30 ≤ q/(p+q) ≤ 0.80, more preferably 0.45 ≤ q/(p+q) ≤ 0.70. Reference is made to JP-A 11-1619.

The silicone resin used as the base polymer is a liquid or solid organopolysiloxane having a viscosity at 25°C of at least 10 mPa·s, more preferably at least 100 mPa·s, even more preferably at least 10,000 mPa·s. In component (A), a straight chain diorganopolysiloxane which contains alkenyl groups (e.g., vinyl) bonded to silicon atoms at ends of the molecular chain, silicon atoms midway the molecular chain, or silicon atoms at ends of and midway the molecular chain, whose backbone consists essentially of recurring diorganosiloxane units, which is capped with triorganosiloxy groups at both ends of the molecular chain, and which may or may not contain phenyl groups may be blended as an optional component for the purposes of adjusting the viscosity of the composition or the hardness of the cured product and so on.

Component (B) is an organohydrogensilane and/or an organohydrogenpolysiloxane, which serves as a crosslinking agent for causing the composition to cure, by inducing hydrosilylation reaction with the alkenyl group-containing silicone resin (A). Component (B) is an organohydrogenpolysiloxane having at least two, especially at least three SiH bonds in a molecule represented by the average compositional formula (2):

R'ₐH_{b}SiO_{(4-a-b)/2} (2)

wherein R' is independently selected from substituted or unsubstituted monovalent hydrocarbon groups excluding aliphatic unsaturated hydrocarbon groups, "a" and "b" are positive numbers satisfying 0.7 ≤ a s 2.1, 0.001 s b s 1.0, and 0.8 ≤ a+b ≤ 2.6, preferably 0.8 ≤ a ≤ 2, 0.01 s b s 1, and 1 ≤ a+b ≤ 2.4, and having a viscosity of up to 1,000 mPa·s at 25°C and/or an organohydrogensilane represented by the formula: R'_{c}SiH_{(4-c)} wherein R' is as defined above and c is 1 or 2.

Examples of the monovalent hydrocarbon groups represented by R' are as exemplified for R in formula (1), with those free of aliphatic unsaturation being preferred.

Typical examples of the organohydrogensilane and organohydrogenpolysiloxane include (CH₃)SiH₃, (CH₃)₂SiH₂, (C₆H₅)SiH₃, 1,1,3,3-tetramethyldisiloxane, 1,3,5,7-tetramethylcyclotetrasiloxane, both end trimethylsiloxy-capped methylhydrogenpolysiloxane, both end trimethylsiloxy-capped dimethylsiloxanemethylhydrogensiloxane copolymers, both end dimethylhydrogensiloxy-capped dimethylpolysiloxane, both end dimethylhydrogensiloxy-capped dimethylsiloxanemethylhydrogensiloxane copolymers, both end trimethylsiloxy-capped methylhydrogensiloxanediphenylsiloxane copolymers, both end trimethylsiloxy-capped methylhydrogensiloxanediphenylsiloxane-dimethylsiloxane copolymers, copolymers consisting of (CH₃)₂HSiO_{1/2} units and SiO_{4/2} units, and copolymers consisting of (CH₃)₂HSiO_{1/2} units, SiO_{4/2} units and (C₆H₅)SiO_{3/2} units.

The molecular structure of the organohydrogenpolysiloxane may be a straight, branched, cyclic or three-dimensional network structure. The number of silicon atoms per molecule, i.e., degree of polymerization is preferably in the range of about 3 to about 1,000, more preferably about 3 to about 300.

The organohydrogenpolysiloxane has a viscosity at 25°C of up to 1,000 mPa·s, more preferably 0.1 to 500 mPa·s, even more preferably 0.5 to 300 mPa·s.

It is preferable that when the silicone resin (A) has a phenyl group, the organohydrogensilane and/or organohydrogenpolysiloxane as component (B) has a phenyl group as well because this ensures transparency and prevents separation during shelf storage. Phenyl group content of all groups on silicon (R' and hydrogen atoms) in formula (2) is preferably at least 5 mol%, more preferably at least 8 mol% or at least 10 mol%. It is preferably up to 50 mol%, more preferably up to 30 mol%. Also preferably, component (B) is a mixture of an organohydrogenpolysiloxane of formula (2) wherein less than 15 mol%, especially 10 mol% to less than 15 mol% of the entire groups bonded to silicon atoms (R' and hydrogen atoms) are phenyl groups and an organohydrogenpolysiloxane of the compositional formula (2) wherein at least 15 mol%, especially 15 mol% to 50 mol% of the entire groups bonded to silicon atoms (R' and hydrogen atoms) (preferred values as above) are phenyl groups. Preferred weight ratio of these is between 1:9 and 9:1, especially 3:7 to 7:3.

The amount of the organohydrogensilane and/or organohydrogenpolysiloxane blended as component (B) is 2 to 100 parts by weight, preferably 10 to 100 parts by weight per 100 parts by weight of the silicone resin (A).

Also, the organohydrogensilane and/or organohydrogenpolysiloxane as component (B) is used in such amounts that the molar ratio of silicon atom-bonded hydrogen atoms (i.e., SiH groups) in component (B) to silicon atom-bonded alkenyl groups in the silicone resin or the silicone resin and the optional alkenyl group-containing straight chain diorganopolysiloxane combined as component (A) may fall in the range of 0.5 to 5 mol/mol, preferably 0.8 to 4 mol/mol, and more preferably 1 to 3 mol/mol. (The upper and lower limits are independent of one another).

Component (C) is an addition reaction catalyst for promoting the hydrosilylating addition reaction between alkenyl groups in component (A) and SiH groups in component (B). Typical addition reaction catalysts are platinum group metal catalysts including platinum catalysts such as platinum black, platinum chloride, chloroplatinic acid, the reaction products of chloroplatinic acid with monohydric alcohols, complexes of chloroplatinic acid with olefins, and platinum bisacetoacetate, palladium catalysts, and rhodium catalysts. The addition reaction catalyst may be used in a catalytic amount, preferably in such an amount to give about 1 to 500 ppm, especially about 2 to 100 ppm of platinum group metal based on the weight of components (A) and (B) combined.

In addition to components (A) to (C) described above, the inventive composition may further comprise optional components insofar as the objects of the invention are not compromised. Suitable optional components include addition reaction inhibitors for adjusting cure and imparting a pot life, and hardness or viscosity-adjusting agents, for example, non-reactive straight chain organopolysiloxanes and straight chain or cyclic low-molecular-weight organopolysiloxanes having about 2 to about 10 silicon atoms as well as the above-described alkenyl group-containing straight chain diorganopolysiloxane which may or may not contain a phenyl group, such as dimethylpolysiloxane.

Insofar as transparency is not impaired, there may be blended inorganic fillers such as fumed silica for enhancing strength. If desired, wavelength adjusting agents, dyes, pigments, flame retardants, heat resistance improvers and antidegradants may also be blended.

The composition may be cured under any desired conditions although it is preferably cured by heating at about 120 to 180°C for about 30 to 180 minutes.

The silicone resin compositions are used with LED devices for the purposes of protection, encapsulation, bonding, wavelength alteration or adjustment, and lens formation of LED devices and afford transparent cured products having heat resistance and discoloration resistance.

### EXAMPLE

Examples of the invention are given below by way of illustration and not by way of limitation.

### Example 1

A reactor was charged with toluene, ethyl polysilicate, vinyldimethylchlorosilane, and trimethylchlorosilane. Co-hydrolytic polymerization was effected, yielding a 50 wt% toluene solution of an organopolysiloxane resin copolymer (silicone resin) consisting of CH₂=CH(CH₃)₂SiO_{1/2} units, (CH₃)₃SiO_{1/2} units and SiO₂ units, and having a ratio of [(CH₃)₃SiO_{1/2} units + CH₂=CH(CH₃)2SiO_{1/2} units]/SiO₂ units equal to 0.85 mol/mol and a vinyl group content of 0.02 mol/100 g. This was combined with an equal amount calculated as solids of a vinyl end-capped dimethylpolysiloxane having a viscosity of 500 mPa·s at 23°C. The mixture was vacuum stripped at 150° C until the depletion of strippable matter, yielding a liquid material having a viscosity of 30,000 mPa·s. To 100 parts by weight of this silicone resin as the base were added an amount of a platinum catalyst to give 20 ppm platinum element and 0.5 part by weight of tetravinyltetramethyltetracyclosiloxane as a reaction inhibitor. To 100 parts by weight of this mixture was added 6 parts by weight of methylhydrogensiloxane capable of generating 350 ml/g of hydrogen gas and having a viscosity of 20 mPa·s at 23°C as a curing agent. They were mixed and deaerated, after which the composition was cast into a glass plate-assembled mold to a thickness of 3 mm where it was cured at 120°C for one hour.

### Example 2

A reactor was charged with toluene, phenyltrichlorosilane, vinylmethyldichlorosilane, and dimethyldichlorosilane. Co-hydrolytic polymerization was effected, yielding a 50 wt% toluene solution of an organopolysiloxane resin copolymer (silicone resin) consisting of (C₆H₅)SiO_{3/2} units, (CH₂=CH)(CH₃)SiO_{2/2} units and (CH₃)₂SiO_{2/2} units, and having an average compositional formula: (CH₃)_{0.65}(C₆H₅)_{0.55}(CH₂=CH)_{0.25}SiO_{1.28}. To 100 parts by weight of this silicone resin dissolved was added 10 parts by weight of a phenylmethylhydrogensiloxane containing 20 mol% of phenyl groups based on the total of silicon atom-bonded methyl groups, phenyl groups and hydrogen atoms (SiH groups), capable of generating 150 ml/g of hydrogen gas and having a viscosity of 10 mPa·s. After mixing, the mixture was vacuum stripped at 150°C until the depletion of strippable matter. The mixture was cooled to room temperature, after which 0.2 part by weight of ethynyl cyclohexanol as a reaction inhibitor was added. To the mixture was added an amount of a platinum catalyst to give 20 ppm platinum element. They were mixed by agitation and deaerated, after which the composition was cast into a mold as in Example 1 where it was cured at 120°C for 30 minutes. The cured product was taken out of the mold and post-cured in a drier at 180°C for 2 hours, obtaining a sample.

### Example 3

A reactor was charged with toluene, phenyltrichlorosilane, vinylmethyldichlorosilane, and dimethyldichlorosilane. Co-hydrolytic polymerization was effected, yielding a 50 wt% toluene solution of an organopolysiloxane resin copolymer (silicone resin) consisting of (C₆H₅)SiO_{3/2} units, (CH₂=CH)(CH₃)SiO_{2/2} units and (CH₃)₂SiO_{2/2} units, and having an average compositional formula: (CH₃)_{0.65}(C₆H₅)_{0.55}(CH₂=CH)_{0.25}SiO_{1.28}. To 100 parts by weight of this silicone resin dissolved were added 20 parts by weight of a phenylmethylhydrogensiloxane containing 20 mol% of phenyl groups based on the total of silicon atom-bonded methyl groups, phenyl groups and hydrogen atoms (SiH groups), capable of generating 150 ml/g of hydrogen gas and having a viscosity of 10 mPa·s and 10 parts by weight of a phenylmethylhydrogensiloxane containing 10 mol% of phenyl groups based on the total of silicon atom-bonded methyl groups, phenyl groups and hydrogen atoms (SiH groups), capable of generating 120 ml/g of hydrogen gas and having a viscosity of 20 mPa·s. After mixing, the mixture was vacuum stripped at 150°C until the depletion of strippable matter. The mixture was cooled to room temperature, after which 0.2 part by weight of ethynyl cyclohexanol as a reaction inhibitor was added. To the mixture was added an amount of a platinum catalyst to give 20 ppm platinum element. They were mixed by agitation and deaerated, after which the composition was cast into a mold as in Example 1 where it was cured at 120°C for 30 minutes. The cured product was taken out of the mold and post-cured in a drier at 180°C for 2 hours, obtaining a sample.

### Comparative Example

A commercially available transparent epoxy resin material commonly used with lamp type LEDs was cast into a mold as in Example 1 and cured at 150°C for 8 hours, obtaining a sample.

Physical properties of the samples of Examples and Comparative Example are shown in Table 1.

**Table 1**

| Properties | Example 1 | Example 2 | Example 3 | Comparative Example |
|---|---|---|---|---|
| Refractive index of base | 1.41 | 1.51 | 1.51 | 1.51 |
| Hardness (Shore D) | | 75 | 74 | 85 |
| Hardness (Shore A) | 77 | | | |
| Flexural strength* (MPa) | | 100 | 95 | 135 |
| Tensile strength** (MPa) | 5.4 | | | |

| | | | | |
|---|---|---|---|---|
| * JIS K 6911 * JIS K 6249 | | | | |

The samples of Examples and Comparative Example were examined for light transmittance by the following tests.

A sample as prepared was measured for light transmittance at 400 nm, obtaining an initial value. The sample was exposed to ultraviolet radiation in a sunshine weatherometer (Suga Tester Co., Ltd.) for 100 hours and 500 hours, after which light transmittance was measured again. The results are shown in Table 2.

**Table 2**

| Light transmittance | Example 1 | Example 2 | Example 3 | Comparative Example |
|---|---|---|---|---|
| Initial | 95 | 95 | 94 | 97 |
| After 100 hour exposure | 91 | 93 | 92 | 81 |
| After 500 hour exposure | 92 | 91 | 90 | 65 |

Separately, a sample as prepared was held in a drier at 120°C for 100 hours and 500 hours, after which light transmittance was measured again. The results are shown in Table 3.

**Table 3**

| Light transmittance | Example 1 | Example 2 | Example 3 | Comparative Example |
|---|---|---|---|---|
| Initial | 95 | 95 | 94 | 97 |
| After 100 hour heating | 92 | 90 | 92 | 78 |
| After 500 hour heating | 92 | 88 | 90 | 65 |

## Claims

1. The use, in the manufacture of a light-emitting diode (LED) device, of a silicone resin composition curable to a transparent product and comprising:
(A) 100 parts by weight of liquid or solid organopolysiloxane having a viscosity of at least 10 mPa·s at 25°C and represented by the average compositional formula (1):
RₙSiO_{(4-n)/2}
wherein groups R are selected independently from substituted or unsubstituted monovalent hydrocarbon groups, alkoxy groups and hydroxyl group, 0.1 to 80 mol% of the entire R groups being alkenyl groups, and n is a positive number satisfying 1 ≤ n < 2;
(B) 2 to 100 parts by weight of organohydrogenpolysiloxane having at least two SiH bonds per molecule, being represented by the average compositional formula (2) and having a viscosity of up to 1,000 mPa·s at 25°C :
R'ₐH_{b}SiO_{(4-a-b)/2} (2)
wherein groups R' are selected independently from substituted or unsubstituted monovalent hydrocarbon groups, excluding aliphatic unsaturated hydrocarbon groups, a is a positive number from 0.7 to 2.1, b is a positive number from 0.001 to 1.0, and 0.8 ≤ a+b ≤ 2.6, and/or
organohydrogensilane represented by the formula R'_{c}SiH_{(4-c)} wherein R' is as defined above and c is 1 or 2;
(C) a catalytic amount of addition reaction catalyst.

2. Use according to claim 1 wherein component (A) comprises organopolysiloxane having a viscosity of at least 100 mPa·s at 25°C and represented by the average compositional formula (1-1):
Rₚ(C₆H₅)_{q}SiO_{(4-p-q)/2} (1-1)
wherein groups R are as defined previously and p and q are positive numbers satisfying 1 ≤ p+q < 2 and 0.20 ≤ q/(p+q) ≤ 0.95.

3. Use according to claim 1 or 2 wherein component (B) is an organohydrogenpolysiloxane wherein phenyl groups constitute at least 5 mol% of the entire R' and H in the compositional formula (2).

4. Use according to claim 2 or 3 wherein component (B) is a mixture of
- organohydrogenpolysiloxane of said compositional formula (2) and wherein phenyl groups constitute less than 15 mol% of the entire R' and H, and
- organohydrogenpolysiloxane of the compositional formula (2) wherein phenyl groups constitute at least 15 mol% of the entire R' and H,
at a weight ratio between 1:9 and 9:1.

5. Use according to any one of the preceding claims in which the silicone resin composition is used in the LED device for any one or more of protection, bonding, wavelength alteration or adjustment, or lens formation.

6. A light-emitting diode (LED) device encapsulated with a transparent cured silicone resin obtained by a use according to any one of claims 1 to 5.

## Patentansprüche

1. Verwendung bei der Herstellung einer lichtemittierenden Diodenvorrichtung (LED-Vorrichtung) einer Siliconharzzusammensetzung, die zu einem transparenten Produkt härtet und Folgendes umfasst:
(A) 100 Gewichtsteile eines flüssigen oder festen Organopolysiloxans mit einer Viskosität bei 25 °C von zumindest 10 MPa.s und der allgemeinen Zusammensetzungsformel (1):
RₙSiO_{(4-n)/2} (1)
worin die R-Gruppen unabhängig voneinander aus substituierten oder unsubstituierten einwertigen Kohlenwasserstoffgruppen, Alkoxygruppen und Hydroxygruppen ausgewählt sind, wobei 0,1 bis 80 Mol-% der gesamten R-Gruppen Alkenylgruppen sind und n eine positive Zahl ist, für die Folgendes gilt: 1 ≤ n < 2;
(B) 2 bis 100 Gewichtsteile eines Organohydrogenpolysiloxans mit zumindest zwei SiH-Bindungen pro Molekül mit einer Viskosität bei 25 °C von bis zu 1.000 MPa·s und der allgemeinen Zusammensetzungsformel (2):
R'ₐH_{b}SiO_{(4-a-b)/2} (2)
worin die R'-Gruppen unabhängig voneinander aus substituierten oder unsubstituierten einwertigen Kohlenwasserstoffgruppen, ausschließlich aliphatischer ungesättigter Kohlenwasserstoffgruppen, bestehen, a eine positive Zahl von 0,7 bis 2,1 ist, b eine positive Zahl von 0,001 bis 1,0 ist, für die Folgendes gilt: 0,8 ≤ a+b ≤ 2,6, und/oder eines Organohydrogensilans der Formel R'_{c}SiH_{(4-c)}, worin R' wie oben definiert ist und c = 1 oder 2 ist;
(C) eine katalytische Menge eines Additionsreaktionskatalysators.

2. Verwendung nach Anspruch 1, worin die Komponente (A) Organopolysiloxan mit einer Viskosität bei 25 °C von zumindest 100 MPa·s umfasst und folgende mittlere Zusammensetzungsformel (1-1) aufweist:
Rₚ(C₆H₅)_{q}SiO_{(4-p-q)/2} (1-1)
worin die R-Gruppen wie zuvor definiert sind und p und q positive Zahlen sind, für die Folgendes gilt: 1 ≤ p+q < 2 und 0,20 ≤ q/(p+q) ≤ 0,95.

3. Verwendung nach Anspruch 1 oder 2, worin Komponente (B) ein Organohydrogenpolysiloxan ist, worin Phenylgruppen zumindest 5 Mol-% der gesamten R' und H in der Zusammensetzungsformel (2) ausmachen.

4. Verwendung nach Anspruch 2 oder 3, worin Komponente (B) ein Gemisch aus
- Organohydrogenpolysiloxan der Zusammensetzungsformel (2), worin Phenylgruppen weniger als 15 Mol-% der gesamten R' und H ausmachen, und
- Organohydrogenpolysiloxan der Zusammensetzungsformel (2), worin Phenylgruppen zumindest 15 Mol-% der gesamten R' und H ausmachen,
bei einem Gewichtsverhältnis zwischen 1:9 und 9:1 ist.

5. Verwendung nach einem der vorangegangenen Ansprüche, worin die Siliconharzzusammensetzung in der LED-Vorrichtung beliebig zum Schutz, zur Bindung, Wellenlängenveränderung oder -einstellung oder Linsenausbildung oder mehr verwendet wird.

6. Lichtemittierende Diodenvorrichtung (LED-Vorrichtung), die mit einem transparenten gehärteten Siliconharz umhüllt ist, das durch die Verwendung nach einem der Ansprüche 1 bis 5 erhalten wird.

## Revendications

1. Utilisation, dans la fabrication d'un dispositif de diode électroluminescente (DEL), d'une composition de résine de silicone vulcanisable en un produit transparent et comprenant :
(A) 100 parties en poids d'un liquide ou d'un solide organopoly(siloxane) ayant une viscosité d'au moins 10 mPa.s à 25° C et représenté par la formule compositionnelle moyenne (1) :
RₙSiO_{(4-n)/2}
dans laquelle les groupes R sont indépendamment choisis parmi des groupes hydrocarbures monovalents substitués ou non substitués, des groupes alcoxy ou un groupe hydroxyle, 0,1 à 80 % en mol de l'ensemble des groupes R étant des groupes alcényle, et n est un nombre positif satisfaisant 1 ≤ n < 2 ;
(B) 2 à 100 parties en poids d'un organohydrogénopoly(siloxane) ayant au moins deux liaisons SiH par molécule, représenté par la formule compositionnelle moyenne (2) et ayant une viscosité allant jusqu'à 1 000 mPa.s à 25° C :
R'ₐH_{b}SiO_{(4-a-b)/2} (2)
dans laquelle les groupes R sont indépendamment choisis parmi des groupes hydrocarbures monovalents substitués ou non substitués, à l'exception des groupes hydrocarbures insaturés aliphatiques, a est un nombre positif allant de 0,7 à 2,1 , b est un nombre positif allant de 0,001 à 1,0 et 0,8 ≤ a+b ≤ 2,6, et/ou
un organohydrogénosilane représenté par la formule R'_{c}SiH_{(4-c)} dans laquelle R' est tel que défini ci-dessus et c vaut 1 ou 2 ;
(C) une quantité catalytique d'un catalyseur de réaction d'addition.

2. Utilisation selon la revendication 1, dans laquelle le composant (A) comprend un organopoly(siloxane) ayant une viscosité d'au moins 100 mPa·s à 25° C et représenté par la formule compositionnelle moyenne (1-1) :
Rₚ(C₆H₅)_{q}SiO_{(4-p-q)/2} (1-1)
dans laquelle les groupes R sont tels que définis précédemment et p et q sont des nombres positifs satisfaisants 1 ≤ p+q < 2 et 0,20 ≤ q/(p+q) ≤ 0,95.

3. Utilisation selon la revendication 1 ou 2 dans laquelle le composant (B) est un organohydrogénopoly(siloxane) dans lequel les groupes phényle constituent au moins 5 % en mol de l'ensemble des R' et H dans la formule compositionnelle (2).

4. Utilisation selon la revendication 2 ou 3, dans laquelle le composant (B) est un mélange
- d'un organohydrogénopoly(siloxane) de ladite formule compositionnelle (2) et dans laquelle les groupes phényle constituent moins de 15 % en mol de l'ensemble des R' et H, et
- d'un organohydrogénopoly(siloxane) de la formule compositionnelle (2) dans laquelle les groupes phényle constituent au moins 15 % en mol de l'ensemble des R' et H,
à un rapport en poids entre 1 : 9 et 9 :1.

5. Utilisation selon l'une quelconque des revendications précédentes, dans laquelle la composition de résine de silicone est utilisée dans le dispositif DEL pour une ou plusieurs applications quelconques parmi la protection, la liaison, la modification de longueur d'onde ou l'ajustement, ou la formation de lentille.

6. Dispositif de diode électroluminescente (DEL) encapsulé avec une résine de silicone vulcanisée transparente obtenue par une utilisation selon l'une quelconque des revendications 1 à 5.
